# EUROPEAN PATENT APPLICATION

(11) **EP 2 927 464 A1**
(43) Date of publication of application: **07.10.2015**
(21) Application number: 15158910.8
(22) Date of filing: 13.03.2015
(51) Int. Cl.: F02D 21/08, F02P 19/02, F02B 1/12, F02D 35/02

(54) **DIESEL ENGINE CONTROL APPARATUS, DIESEL ENGINE CONTROL METHOD, AND METHOD FOR DESIGNING DIESEL ENGINE CONTROL APPARATUS**

(30) Priority: 26.03.2014 JP 2014063743; 26.06.2014 JP 2014130971
(71) Applicant: NGK Spark Plug Co., Ltd., Nagoya-shi, Aichi 467-8525 (JP)
(72) Inventor: Tanaka, Takafumi, Nagoya-shi, Aichi 467-8525 (JP); Honma, Tetsuharu, Nagoya-shi, Aichi 467-8525 (JP); Nakamura, Toshiyuki, Nagoya-shi, Aichi 467-8525 (JP); Okinaka, Manabu, Nagoya-shi, Aichi 467-8525 (JP)
(74) Representative: Grünecker Patent- und Rechtsanwälte PartG mbB

(57) **Abstract**

[Objective] To suppress torque variation, etc. when a diesel engine is switched to premixed combustion.

[Means for Solution] Wen the diesel engine is switched to premixed combustion in a state in which EGR is being performed, the interior of a cylinder of the diesel engine is heated by a cylinder heater. Also, at least fuel injection timing control for the diesel engine is performed.

## Description

### [Technical Field]

The present invention relates to control of a diesel engine.

### [Background Art]

Conventionally, there has been proposed a technique for controlling a diesel engine in a combustion form (mode) corresponding to the load of the engine (see, for example, the below-listed Patent Document 1). Combustion forms (also called "combustion modes") of fuel employed in such engine control include a diffusion combustion mode for combusting fuel while injecting the fuel into a combustion chamber, and a premixed combustion mode (also called "homogeneous-charge compression combustion mode") for mixing fuel and air within a combustion chamber before igniting the fuel. In general, the diffusion combustion mode is used when the engine is in a high-load state, and the premixed combustion mode is used when the engine is in a low-load state. Also, in the premixed combustion, EGR control for re-circulating a large amount of exhaust gas to the intake side is used at the same time. It has been known that the amounts of NOx, soot, etc. can be reduced by switching the combustion mode to the premixed combustion mode.

When the combustion mode is switched from the diffusion combustion mode to the premixed combustion mode or switched from a motoring state to the premixed combustion mode, nitrogen oxide (NOx), soot (soot itself or opacity of exhaust gas), combustion noise, etc. may be generated or their amounts may increase. In order to solve the above-described problems, in the below-listed Patent Document 2, fuel injection is divided into pilot injection and main injection, and an increase or decrease in the fuel injection amount during such a transition period is finely adjusted.

### [Prior Art Documents]

### [Patent Documents]

[Patent Document 1] Japanese Patent Application Laid-Open (*kokai*) No. 2007-211612
[Patent Document 2] Japanese Patent Application Laid-Open (*kokai*) No. 2010-236459

### [Summary of the Invention]

### [Problem to be Solved by the Invention]

With regard to such premixed combustion in a diesel engine, it has been known that torque variation and combustion noise increase immediately after the combustion mode is switched to the premixed combustion mode. Conceivably, such a phenomenon occurs because combustion becomes unstable at the time of so-called transition from the diffusion combustion mode to the premixed combustion mode. Immediately after the combustion mode is switched to the premixed combustion mode, the amount of EGR cannot be controlled properly due to, for example, a temporary delay in introduction of exhaust gas. Conceivably, this is one of causes of a problem of the control becoming unstable.

It has been known that, when premixed combustion is performed, the output of the diesel engine, its torque variation, combustion noise, and the amounts of generated NOx and soot can be reduced by adjusting fuel injection timing. However, in particular, during a transition period in which the combustion is switched to the premixed combustion, the range within which fuel injection timing can be controlled is narrow, and it has been difficult to find a fuel injection timing which satisfies various characteristics of the diesel engine. For example, when fuel injection timing is delayed, in general, combustion noise, NOx, etc. can be reduced. In such a case, however, the output of the engine decreases, torque variation increases, and misfire may occur, as has been pointed out. Meanwhile, when fuel injection timing is advanced, the possibility of misfire can be decreased. In this case, however, combustion proceeds rapidly, and combustion noise and NOx may increase as a result of occurrence of knocking. As described above, in a transition period in which the combustion form is switched, the region within which fuel injection timing can be controlled always changes, and the range within which fuel injection timing can be controlled properly is narrow. Therefore, proper control of fuel injection timing has been difficult.

### [Means for Solving the Problem]

The present invention has been accomplished so as to solve, at least partially, the above-described problem, and the present invention can be embodied in the following modes.
(1) A diesel engine control apparatus for controlling combustion in a diesel engine is provided as a first mode of the present invention. This diesel engine control comprises a cylinder heater for heating the interior of a cylinder of the diesel engine; and a control unit which performs the heating of the interior of the cylinder by the cylinder heater when the diesel engine is switched to premixed combustion in a state in which EGR is being performed, and performs at least fuel injection timing control for the diesel engine.

According to such a diesel engine control apparatus, the glow plug is energized when the diesel engine is switched to premixed combustion. Therefore, the characteristics of the engine determined by the fuel injection timing control can be improved.

(2) In such a diesel engine control apparatus, the control unit may control the EGR when the diesel engine is switched to the premixed combustion such that the EGR ratio becomes equal to or greater than a predetermined EGR ratio. Since the EGR ratio is made equal to or greater than the predetermined EGR ratio in the premixed combustion, the amount of generated NOx and the amount of generated soot can be suppressed.
(3) In the above-described diesel engine control apparatus, the control unit may perform control of the fuel injection timing to a delay side while controlling the EGR such that the EGR ratio becomes equal to or greater than the predetermined EGR ratio. By virtue of this, the fuel injection timing can be delayed as compared with that in an ordinary case. This, coupled with the heating of the interior of the cylinder by the cylinder heater, can reduce cycle variation, combustion noise, NOx, etc.

(4) In such a diesel engine control apparatus, the heating by the cylinder heater may be performed immediately before the diesel engine is switched to the premixed combustion. Since the glow plug requires a significant time to reach the predetermined temperature after the start of energization, it is desired to perform the heating in consideration of that time.

(5) Further, the cylinder heater may be a glow plug which can increase its temperature to 900°C or higher. This is because when the temperature increase caused by the heating exceeds 900°C, a particularly significant difference is observed in the fuel injection timing.

(6) In this case, the glow plug may have a temperature increase speed such that the glow plug reaches 1200°C within a period of 0.5 sec to 3 sec. If the temperature can be increased to a required temperature within a short period of time, the diesel engine can quickly move to the premixed combustion.

(7) A method for controlling combustion in a diesel engine is provided as a second mode of the present invention. This control method comprises heating the interior of a cylinder of the diesel engine by a cylinder heater when the diesel engine is switched to premixed combustion in a state in which EGR is being performed; and performing at least fuel injection timing control for the diesel engine. According to such a diesel engine control method, the glow plug is energized when the diesel engine is switched to premixed combustion. Therefore, the characteristics of the engine determined by the fuel injection timing control can be improved.

(8) A method for designing a control apparatus for controlling combustion in a diesel engine is provided as a third mode of the present invention. This designing method comprises measuring a delay angle limit of fuel injection timing control at the time when the diesel engine is switched to premixed combustion, while using, as parameters, a heating temperature of a cylinder heater which heats the interior of a cylinder of the diesel engine and an EGR ratio of the diesel engine; determining, on the basis of results of the measurement, an advancing amount of the fuel injection timing control of the diesel engine at the time when the diesel engine is switched to premixed combustion, the advancing amount being determined for each value of the EGR ratio in the case where the interior of the cylinder is heated to a predetermined temperature by the cylinder heater; and designing the control unit to control the fuel injection timing of the diesel engine on the basis of the determined advancing amount when the diesel engine is switched to the premixed combustion.

According to such a method for designing a diesel engine control apparatus, the advancing amount of the fuel injection timing at the time when the engine is switched to the premixed combustion can be determined properly. The advancing angle in this case is determined such that the advanced fuel injection timing is located on the delay side as compared with that in the case where the glow plug is not energized.
(9) In such a designing method, the control of the fuel injection timing performed by the control unit may be controlling the fuel injection timing to the determined advancing amount, for each value of the EGR ratio, under the premise that the heating temperature of the cylinder heater is the predetermined temperature, when the diesel engine is switched to the premixed combustion. According such a designing method, a proper fuel injection timing can be determined for each value of the EGR ratio.

(10) In such a designing method, the advance amount by which the fuel injection timing is advanced by the control unit may be determined such that combustion noise of the diesel engine or at least one of NOx (nitrogen oxide), CO (carbon monoxide), THC (total hydrocarbon), and soot in exhaust gas is suppressed. According such a designing method, a diesel engine control apparatus which suppresses at least one of these parameters can be designed easily.

All the plurality of constituent elements of each mode of the present invention are not essential. In order to solve, partially or entirely, the above-mentioned problem or yield, partially or entirely, the effects described in the present specification, a part of the elements may be properly modified, deleted, or replaced with another new element, or the limitation thereof may be partially removed. Also, in order to solve, partially or entirely, the above-mentioned problem or yield, partially or entirely, the effects described in the present specification, a portion or all of the above-described technical features contained in one mode of the present invention may be combined with a portion or all of the above-described technical features contained in other modes of the present invention to thereby attain an independent mode of the present invention.

The present invention can be realized in various forms other than the apparatus. For example, the present invention can be realized in the form of, for example, a fuel injection control apparatus, a fuel injection timing control method, a method for manufacturing a diesel engine control apparatus, a method for controlling a diesel engine control apparatus, a computer program for realizing the control method, or a non-temporary recording medium on which the computer program is recorded.

### [Brief Description of the Drawings]

[FIG. 1] Schematic diagram of a control apparatus for a diesel engine which is a first embodiment of the present invention.
[FIG. 2] Flowchart showing an engine control routine in the first embodiment.
[FIGS. 3(A) and 3(B)] Explanatory diagrams exemplifying premixed combustion and diffusion combustion regions, combustion modes corresponding to these regions, and a transition period between the combustion modes.
[FIG. 4] Graph showing the relation between fuel injection timing and torque with the heating temperature of a glow plug used as a parameter.
[FIG. 5] Graph showing the relation between fuel injection timing and torque variation with the heating temperature of the glow plug used as a parameter.
[FIG. 6] Graph showing the relation between fuel injection timing and combustion noise with the heating temperature of the glow plug used as a parameter.
[FIG. 7] Graph showing the relation between fuel injection timing and NOx generation amount with the heating temperature of the glow plug used as a parameter.
[FIG. 8] Graph showing the relation between fuel injection timing and CO generation amount with the heating temperature of the glow plug used as a parameter.
[FIG. 9] Graph showing the relation between fuel injection timing and THC generation amount with the heating temperature of the glow plug used as a parameter.
[FIG. 10] Graph showing the relation between fuel injection timing and soot generation amount (opacity) with the heating temperature of the glow plug used as a parameter.
[FIG. 11] Graph showing the relation between fuel injection timing and pressure increase rate maximum value dPmax and the relation between fuel injection timing and indicated means effective pressure (IMEP).
[FIG. 12] Flowchart showing an engine control routine in a second embodiment.
[FIG. 13] Flowchart showing a process of designing fuel injection timing.

### [Modes for Carrying out the Invention]

### A. Hardware configuration of engine control apparatus:

A diesel engine control apparatus which is a first embodiment of the present invention will now be described. The diesel engine control apparatus denoted by 100 is mainly composed of a four-cylinder, direct-injection-type diesel engine (hereinafter simply referred to as an engine) 10; an intake-exhaust system 20 which performs intake and exhaust operations, including recirculation of exhaust gas, for the engine 10; a fuel injection value 30 for supplying fuel (light oil) to the engine 10; and an ECU 70 for controlling the entire operation of the engine 10.

The engine 10 includes four cylinders, and a piston is provided in each cylinder. Motion of the piston pushed downward as a result of combustion of fuel is converted to rotational motion of a crankshaft through a connecting rod. A rotational angle sensor 54 is provided to face the outer periphery of a gear wheel 11 coupled to the crankshaft, and accurately detects the rotational angle of the crankshaft (hereinafter referred to as the "crank angle CA"). The shape of the gear wheel is determined such that the top dead center TDC and bottom dead center BDC of the piston in each cylinder are also detected.

The above-mentioned fuel injection valve 30 and a glow plug 32 including a cylinder pressure sensor are provided on the cylinder head of the engine 10. Also, a water temperature sensor for detecting the temperature of cooling water and other components are provided on the engine 10. In response to an instruction from the ECU 70, the fuel injection valve 30 opens so as to inject into a cylinder of the engine 10 high-pressure fuel supplied from a fuel supply pump 24 via a common rail 26. The timing of this injection represented by a crank angle CA from the top dead center TDC is fuel injection timing. In general, in the diffusion combustion mode, the fuel injection is performed in the vicinity of the top dead center TDC, and in the premixed combustion mode, the fuel injection is performed before the top dead center TDC. An operation of advancing the fuel injection timing in the crank angle CA will be referred to as "controlling the fuel injection timing to the advance side," and an operation of delaying the fuel injection timing in the crank angle CA will be referred to as "controlling the fuel injection timing to the delay side (retarding the fuel injection timing)."

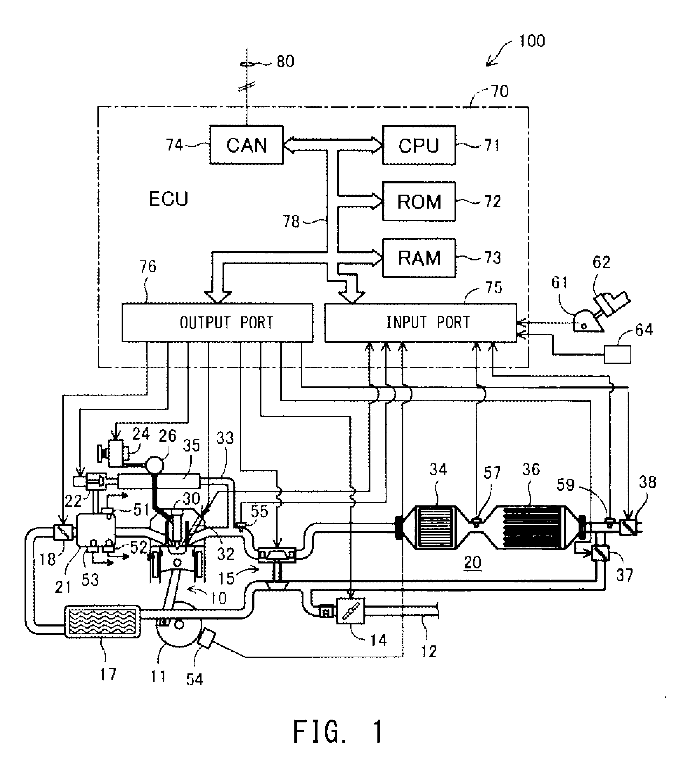

The glow plug 32, which is provided together with the fuel injection valve 30, includes a heater whose temperature reaches 900°C or higher within a short period of time when the heater is energized. The glow plug 32 is used to assist combustion or stabilize combustion at low temperature. Although a cylinder pressure sensor is incorporated into the glow plug 32, this cylinder pressure sensor is not shown in FIG. 1. The glow plug 32 has a heater portion which moves in accordance with the pressure in the cylinder (cylinder pressure) acting on the forward end of the heater portion, and a diaphragm which receives the rear end of the heater portion. A piezo element is provided on the diaphragm. When the heater portion moves due to the cylinder pressure, the diaphragm is distorted, and the resistance of the piezo element changes. The glow plug 32 having such a cylinder pressure sensor converts change in the resistance of the piezo element to an electrical signal, and outputs the electrical signal. This electrical signal is a signal corresponding to the cylinder pressure. The glow plug 32 employed in the present embodiment has a ceramic heater which is provided in the heater portion and which reaches 1200°C within a period of time shorter than that in the case of a metal heater (0.5 to 3.0 sec in the present embodiment). Even when intake gas creates a cooling environment inside the cylinder, the interior of the cylinder can be heated to a temperature of about 1200°C by the glow plug 32 within a short period of time.

Next, the intake-exhaust system 20 will be described. Oxygen is required for combustion in the engine 10, and such oxygen is derived from fresh air introduced from the outside. Fresh air is introduced from an intake pipe inlet 12 through an unillustrated air filter, and is taken into the intake-exhaust system 20 through an intake valve 14. The engine 10 takes in this fresh air and exhaust gas recirculated from an exhaust system as a result of recirculation of of exhaust gas, and uses them for combustion. Gas taken in by the engine 10 will be referred to as "intake gas." A mixture of intake gag taken into the cylinder and fuel injected from the fuel injection valve 30 will be referred to as "gas-fuel mixture."

The intake-exhaust system 20 includes a turbocharger 15, an inter cooler 17, an inter cooler passage throttle valve 18, and an intake manifold (hereinafter simply referred to as "manifold") 21 which are provided in this order from the upstream side between the intake pipe inlet 12 and the intake port of the engine 10. Meanwhile, on the downstream side of the exhaust port of the engine 10, there are provided a branch pipe 33, an exhaust side turbine of the turbocharger 15, an oxidation catalyst 34, an exhaust filter (DPF) 36, and an exhaust shutter 38. Although components on the downstream side of the exhaust shutter 38 are not illustrated, a well-known muffler, etc. are provided, and exhaust gas is released to the atmosphere after being purified by the oxidation catalyst 34 and the DPF 36.

A first EGR valve 37 is provided in a branch passage that branches off at a position before the exhaust shutter 38. Since the branch passage is connected to a flow passage through which fresh air is introduced from the intake pipe inlet 12, a portion of the exhaust gas is mixed with the fresh air there. A mixture of the fresh air and the exhaust gas is introduced into the intake side passage of the turbocharger 15. The turbocharger 15 rotates the exhaust side turbine disposed in the exhaust passage extending from the engine 10 through use of the exhaust gas discharged from the engine 10. Since the exhaust side turbine is connected directly to an intake side turbine disposed on the intake side, the intake side turbine rotates and supercharges the engine 10 with the intake gas. As a result of supercharging by the turbocharger 15, the temperature of the intake gas increases due to adiabatic compression. The inter cooler 17 is provided so as to cool the intake gas. Since the intake gas (fresh air and exhaust gas) cooled by the inter cooler 17 is introduced into the engine 10 through the manifold 21, the exhaust gas is recirculated. The amount of recirculated exhaust gas can be controlled by adjusting the opening of the first EGR valve 37. This passage will be referred to as the "first EGR passage."

Meanwhile, a branch pipe 33 provided immediately after the exhaust port of the engine 10 is connected to the manifold 21 via an EGR cooler 35 and a second EGR valve 22. This passage will be referred to as a second EGR passage for recirculating the exhaust gas from the exhaust side of the engine 10 to the intake side thereof. The EGR amount can be controlled by adjusting the opening of the second EGR valve 22 and the opening of the inter cooler passage throttle valve 18 provided immediately before the manifold 21.

A large number of sensors are provided in the above-described intake-exhaust system 20. An intake gas temperature sensor 51 for detecting the temperature of the intake gas, an intake pressure sensor 52 for detecting the intake pressure, and an oxygen concentration sensor 53 for detecting the oxygen concentration of the intake gas are provided on the manifold 21. An exhaust gas temperature sensor 55 for detecting the temperature of the exhaust gas is provided downstream of the branch pipe 33, and an opacity sensor 57 for detecting the opacity of the exhaust gas (the amount of generated soot) is provided before the DPF 36. Further, an NOx sensor 59 for detecting the amount of NOx is provided before the exhaust shutter 38. Of these sensors, the oxygen concentration sensor 53, the opacity sensor 57, the NOx sensor 59, etc. are provided so as to measure the performance of the engine control apparatus 100, which will be described later, and are not necessarily required for control of the engine 10 actually mounted on a vehicle. Other sensors may be omitted if they are not required for engine control. In the case where the various sensors such as the NOx sensor are not provided, the effects of the control apparatus of the embodiment may be confirmed by measuring various parameters through use of an exhaust gas analyzer, an opacimeter, etc. in a bench test.

The above-described various sensors and actuators such as valves are connected to the ECU 70. The ECU 70 includes a CPU 71 for performing control, a ROM 72, a RAM 73, a CAN 74 for performing communications with an in-vehicle LAN 80, an input port 75 for receiving signals from the sensors, an output port 76 for outputting drive signals to the various valves, and a bus 78 to which these elements and the ports are connected. Various sensors for detecting the operating state of the vehicle, such as an accelerator sensor 61 for detecting the depression amount of an accelerator 62 (hereinafter referred to as the "accelerator depression amount α") and a vehicle speed sensor 64, are also connected to the input port 75.

### B. Engine control:

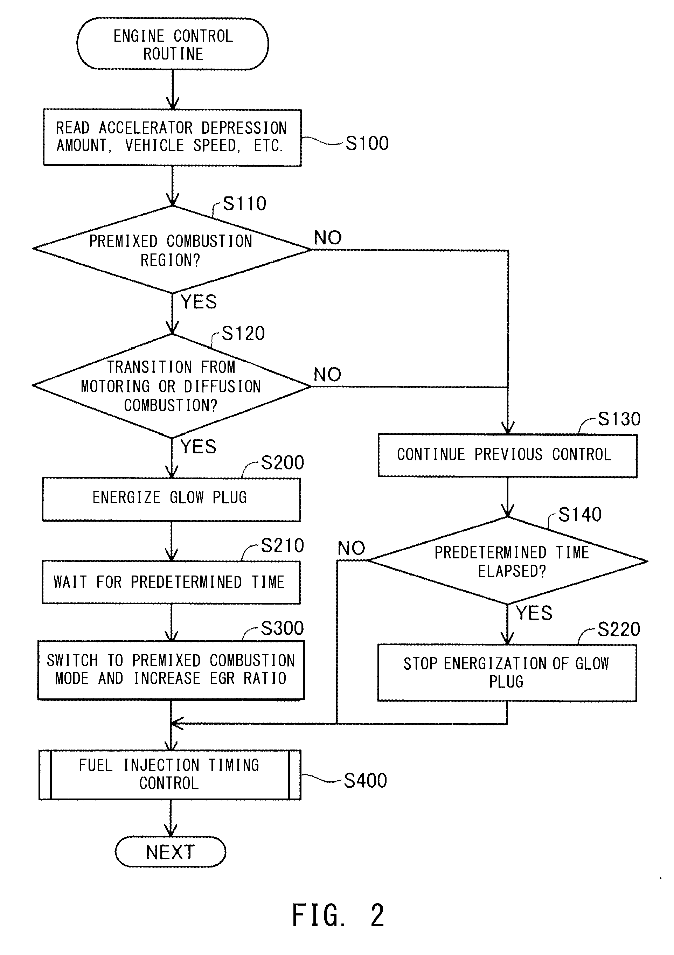

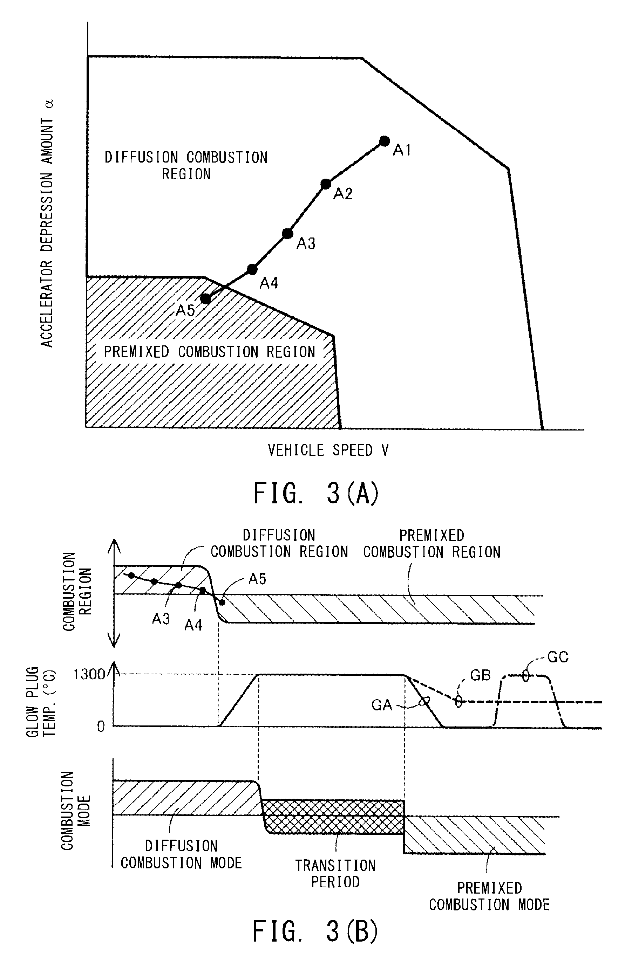

The control apparatus 100 of the first embodiment performs the processing shown in FIG. 2 on the premise that the control apparatus 100 has the above-described hardware configuration. FIG. 2 is a flowchart showing an engine control routine. When operation of the engine 10 is started, the ECU 70 repeatedly executes the processing shown in FIG. 2. When the processing of this routine is started, the ECU 70 receives signals from the sensors such as the accelerator sensor 61 and the vehicle speed sensor 64, and reads the accelerator depression amount α, the vehicle speed V, etc. (step S100). Subsequently, the ECU 70 determines, from the accelerator depression amount α, the vehicle speed V, etc., whether or not the engine is in a region in which the engine operates in the premixed combustion mode (step S110). In general, the premixed combustion mode is employed in a low-speed/low-load region, and the diffusion combustion mode is selected in a region in which the load of the engine is high. Operation regions in which the engine operates in the premixed combustion mode may be determined in advance, and stored in the ROM 72 or the like in the form of a map. An example of the map is shown in FIG. 3(A).

As shown FIG. 3(A), under the assumption that the vehicle speed V and the accelerator depression amount α determine the load of the engine 10, the map is made such that the engine 10 is operated in the premixed combustion mode in a region in which the vehicle speed V and the accelerator depression amount α are small, and the engine 10 is operated in the diffusion combustion mode in a region in which the vehicle speed V and the accelerator depression amount α are large. The map shown in FIG. 3(A) is used for the case where the load to be borne by the engine 10 is determined from the vehicle speed V and the accelerator depression amount α. The output of the engine 10 can be considered as the product of the output torque T and the rotational speed N of the engine 10. In this case, the map of FIG. 3(A) may be made as a two-dimensional map of torque T and rotational speed N.

In the case where the ECU 70 determines that the engine is in a region in which the engine is operated in the premixed combustion mode (step S110: "YES"), subsequently, the ECU 70 determines whether or not the engine is in a transition from a motoring state or the region in which the engine is operated in the diffusion combustion mode (step S120). When the engine is in a transition from the motoring state or the region in which the engine is operated in the diffusion combustion mode, this means that, up to that point in time, the engine has been in the motoring state or has been operated in the diffusion combustion mode, and the engine (engine load) has moved to the region in which the engine is operated in the premixed combustion mode, as a result of changing of the operation state of the vehicle.

One example of the case of transition from the diffusion combustion region to the premixed combustion region is shown by points A1 through A5 in FIG. 3(A). In the case where the load to be borne by the engine 10 (hereinafter referred to as the "required load") is that indicated by a point A1 shown in FIG. 3(A), the engine 10 is operated in the diffusion combustion mode. When the required load decreases gradually (point A2 → point A3 → point A4) and reaches a point A5, the ECU 70 determines that the engine 10 is to be operated in the premixed combustion mode. FIG. 3(B) shows the transition between the combustion regions along the time axis. In this example, the load of the engine changes with time within the diffusion combustion region, and at the point A5, the load of the engine is determined to have entered the premixed combustion region.

In the case where the ECU 70 judges that the present point in time is immediately after the load of the engine has left the diffusion combustion region and entered the premixed combustion region; i.e., a transition between the combustion regions has occurred, (step S120: "YES"), the ECU 70 energizes the glow plug 32 (step S200), and waits for a predetermined time (about 3 seconds in the present embodiment) (step S210). The reason why the ECU 70 waits for the predetermined time is that the ECU 70 waits until the temperature of the glow plug 32 increases to 1300°C. The ceramic-type glow plug 32 used in the present embodiment reaches 1300°C within about 3 seconds. During this period, the diffusion combustion is continued. After elapse of the predetermined time, the ECU 70 performs processing for switching the combustion mode to the premixed combustion mode and processing for increasing the EGR ratio (step S300). After having switched the combustion mode to the premixed combustion mode, the ECU 70 increases the EGR ratio to 40 to 80% by controlling the first and second EGR valves 37 and 22. Exhaust gas is supplied to the intake side via a relatively short path passing through the second EGR valve 22 or a long path passing through the first EGR valve 37. The EGR ratio requires a considerably long time to reach a predetermined EGR ratio in both the case where exhaust gas flows through the relatively short path and the case where exhaust gas flows through the long path. In view of the forgoing, in the present embodiment, a period before the EGR ratio reaches a predetermined value will be referred to as a transition period. As shown in FIG. 3(B), in this transition period, the glow plug 32 is maintained at 1300°C. The action and effects obtained by energizing the glow plug 32 in a state in which EGR is performed will be described later along with fuel injection timing control (step S400).

Meanwhile, when the ECU 70 determines, from the operation state of the vehicle, in the above-described steps S110 and S120 that the engine is not in the region in which the engine is operated in the premixed combustion mode (step S110: "NO") or that the engine is not in the above-described transition period although the engine is in the region in which the engine is operated in the premixed combustion mode (step S120: "NO"), the ECU 70 proceeds to step S130 so as to continue the previous control which has been performed up to that time. The expression "previous control" means that when the engine has been operated in the diffusion combustion mode, the fuel injection control in the diffusion combustion mode is continued, and when the engine has been operated in the premixed combustion mode, the fuel injection control in the premixed combustion mode is continued. Notably, since combustion in the diffusion combustion mode or the premixed combustion mode is conventionally known, it will not be described in detail. Of course, various variations are present in the same diffusion combustion mode or the same premixed combustion mode. However, the routine of FIG. 2, excluding the processing in steps S200 and S210, can be applied to any control.

After the above-described step S130, the ECU 70 determines whether or not the predetermined time has elapsed (step S140). When the predetermined time has elapsed, the ECU 70 performs processing for stopping the energization of the glow plug 32 (step S220). In the present embodiment, the elapse of the predetermined time is judged on the basis of the time from a point in time at which the engine was judged to have entered the premixed combustion region. Accordingly, the energization of the glow plug 32 is usually stopped when the transition period ends. It is judged that the energization of the glow plug 32 becomes unnecessary when the predetermined time has elapsed after the start of the transition from the diffusion combustion region to the premixed combustion region. Notably, the transition period may be the same as or differ from the period during which the glow plug is energized (step S140: "predetermined time").

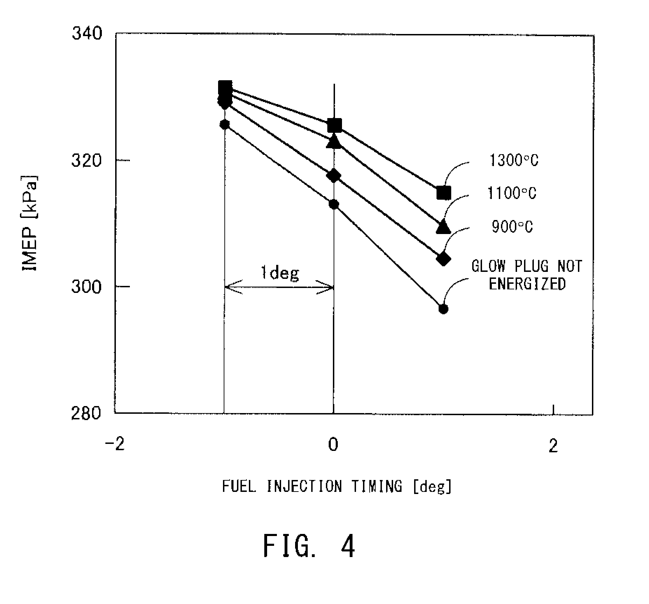

After the above-described processing, the ECU 70 executes the fuel injection timing control (step S400). In the diesel engine 10, the fuel injection timing greatly affects the combustion state. The fuel injection amount is determined from the vehicle speed V and the accelerator depression amount α. In the present embodiment, fuel injection timing is determined to secure the torque required for the vehicle. After the fuel injection amount is obtained from the vehicle speed V and the accelerator depression amount α, a fuel injection timing which allows a necessary torque to be obtained by this fuel injection amount is determined with reference to a predetermined map, and fuel injection is performed at the determined fuel injection timing. This point will be described with reference to a drawing. FIG. 4 is a graph which shows the relation between fuel injection timing and torque (indicated means effective pressure (IMEP)) for the case where the EGR ratio is about 40% and in which the heating temperature of the glow plug 32 is used as a parameter.

In the present embodiment, the glow plug 32 is energized immediately after the transition from the motoring state or the diffusion combustion region to the premixed combustion region, and the combustion mode is switched to the premixed combustion mode after elapse of a predetermined time. Namely, the energization of the glow plug 32 is performed immediately before the combustion mode is switched from the diffusion combustion mode to the diffusion combustion mode. When at least the predetermined time has elapsed, the glow plug 32 has an elevated temperature of 1300°C. Accordingly, when comparison is made for the same IMEP value, it is found that the fuel injection timing in the case where the glow plug 32 is energized to have an elevated temperature of 1300°C can be delayed (retarded) by about 1 CA [deg] as compared with the fuel injection timing in the case where the glow plug 32 is not energized. FIG. 4 shows that fuel injection timing can be controlled to a delayed (retarded) angle - 1 CA [deg]. Notably, in the present embodiment, if the temperature of the glow plug 32 can be increased at least to about 900°C, there can be attained an effect of increasing torque as compared with the case where the glow plug 32 is not energized. Notably, it was observed that the torque increasing effect is enhanced by increasing the reaching temperature of the glow plug 32 to 1000°C, and then to 1300°C.

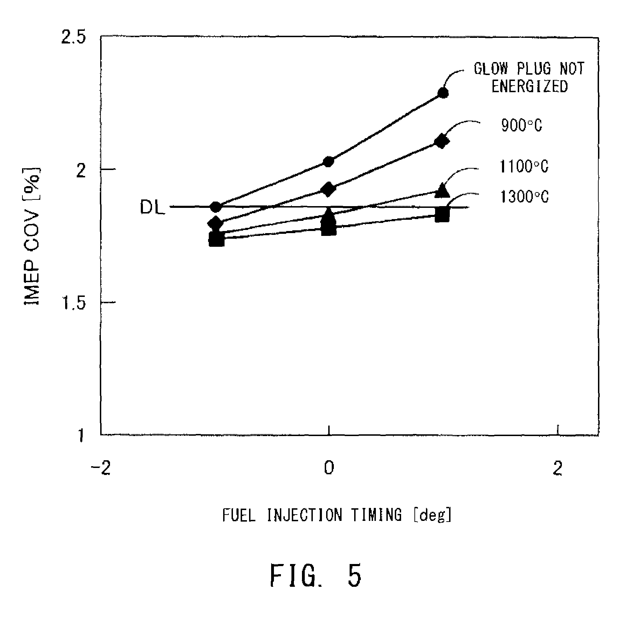

As described above, in the present embodiment, since the temperature of the glow plug 32 is increased to 1300°C by energizing the glow plug 32, the fuel injection timing can be delayed (retarded). When the fuel injection timing is delayed, various desirable effects occur in the diesel engine 10. Improvement of various characteristics will be described with reference to FIGS. 5 through 10. FIGS. 5 through 10 show the characteristics in the case where the EGR ratio is about 40% as in the case of FIG. 4.
(A) Reduction of torque variation:
   FIG. 5 is a graph showing the relation between fuel injection timing and cycle variation (IMEP COV %). As shown in FIG. 5, by delaying the fuel injection timing by 1 CA [deg] in a state in which the temperature of the glow plug 32 has been increased to 1300°C through energization of the glow plug 32, the torque variation of the diesel engine 10 is decreased as compared with the case where the glow plug 32 is not energized and the fuel injection timing is not delayed.

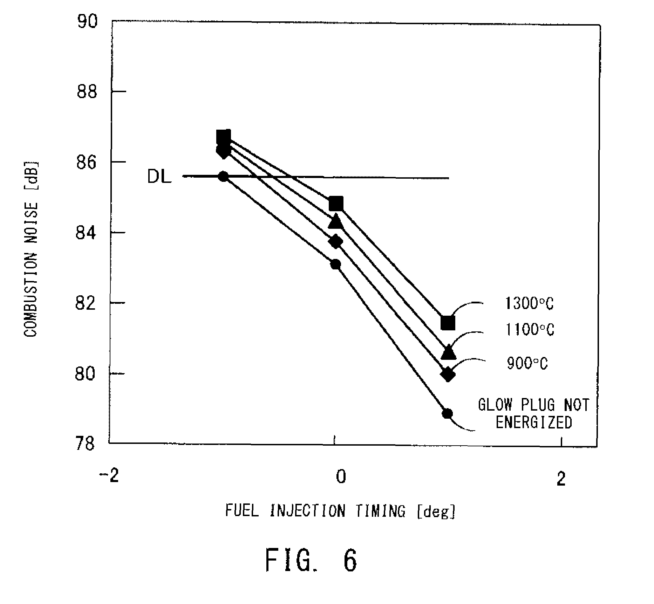

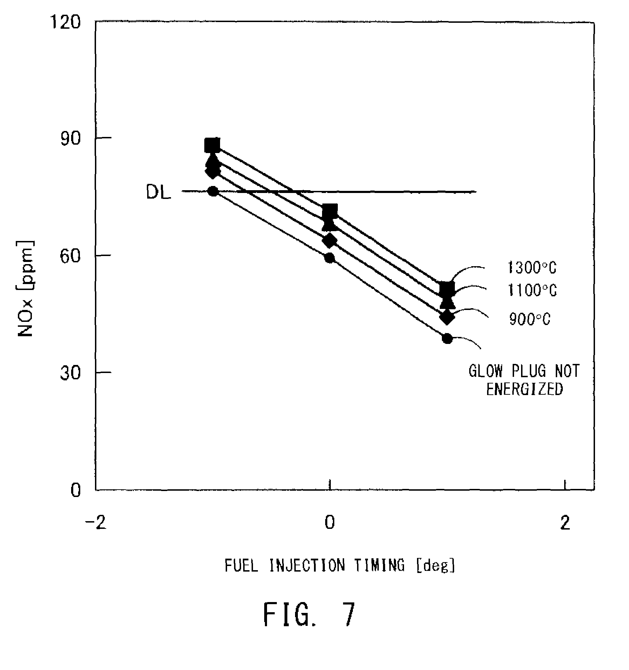

(B) FIG. 6 is a graph which shows the relation between fuel injection timing and combustion noise and in which the heating temperature of the glow plug is used as a parameter. As shown in FIG. 6, when the temperature of the glow plug 32 is increased to 1300°C by energizing the glow plug 32, the generated combustion noise increases as compared with the case where the glow plug 32 is not energized. However, as a result of the fuel injection timing being delayed by 1 CA [deg], the generated combustion noise is decreased as compared with the case where the fuel injection timing is not delayed and the glow plug 32 is not energized. The combustion noise in the case where the fuel injection timing is not delayed and the glow plug 32 is not energized is indicated by a judgment line DL in FIG. 6. It is understood that in the case where the fuel injection timing is delayed by 1 CA [deg], the combustion noise is lower than the judgment line DL even when the temperature of the glow plug is 1300°C. Notably, in FIGS. 7 through 10 as well, the judgment line DL is similarly shown.
(C) FIG. 7 is a graph which shows the relation between fuel injection timing and NOx generation amount and in which the heating temperature of the glow plug is used as a parameter. As shown in FIG. 7, when the temperature of the glow plug 32 is increased to 1300°C by energizing the glow plug 32, the amount of generated NOx increases as compared with the case where the glow plug 32 is not energized. However, as a result of the fuel injection timing being delayed by 1 CA [deg], the amount of generated NOx is decreased to approximately the same level as that in the case where the fuel injection timing is not delayed and the glow plug 32 is not energized (the judgment line DL).

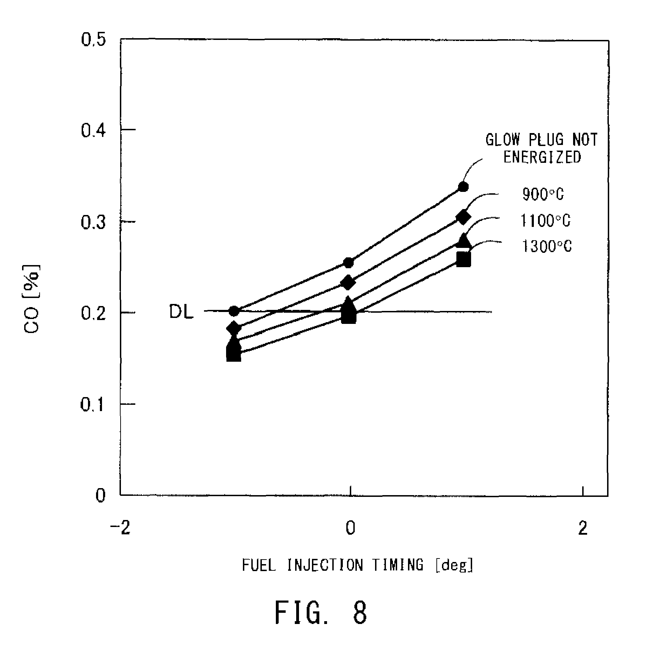

(D) FIG. 8 is a graph which shows the relation between fuel injection timing and CO generation amount and in which the heating temperature of the glow plug is used as a parameter. As shown in FIG. 8, when the temperature of the glow plug 32 is increased to 1300°C by energizing the glow plug 32, the amount of generated CO decreases as compared with the case where the glow plug 32 is not energized. Of course, the amount of generated CO increases when the fuel injection timing is controlled to the delay side. However, even when the fuel injection timing is delayed by 1 CA [deg], the amount of generated CO is decreased as compared with the case where the fuel injection timing is not delayed and the glow plug 32 is not energized (the judgment line DL).

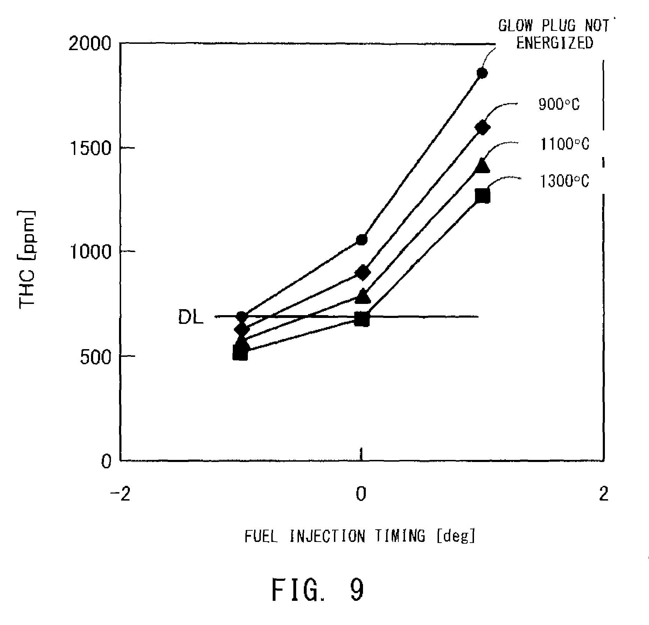

(E) FIG. 9 is a graph which shows the relation between fuel injection timing and THC generation amount and in which the heating temperature of the glow plug is used as a parameter. As shown in FIG. 9, when the temperature of the glow plug 32 is increased to 1300°C by energizing the glow plug 32, the amount of generated THC decreases as compared with the case where the glow plug 32 is not energized. Of course, the amount of generated THC increases when the fuel injection timing is controlled to the delay side. However, even when the fuel injection timing is delayed by 1 CA [deg], the amount of generated THC is decreased as compared with the case where the fuel injection timing is not delayed and the glow plug 32 is not energized (the judgment line DL).

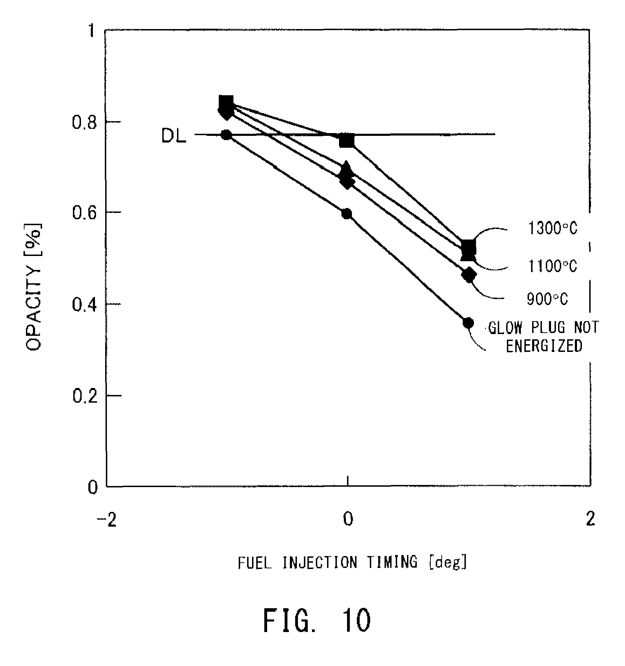

(F) FIG. 10 is a graph which shows the relation between fuel injection timing and soot generation amount (opacity) and in which the heating temperature of the glow plug is used as a parameter. As shown in FIG. 10, when the temperature of the glow plug 32 is increased to 1300°C by energizing the glow plug 32, the amount of generated soot increases as compared with the case where the glow plug 32 is not energized. However, as a result of the fuel injection timing being delayed by 1 CA [deg], the generated soot can be decreased to an amount approximately the same as that in the case where the fuel injection timing is not delayed and the glow plug 32 is not energized (the judgment line DL).

As described above, according to the present embodiment, when the load of the vehicle decreases and enters the region within which the diesel engine 10 is to be operated in the premixed combustion mode, the temperature of the glow plug 32 is increased by energizing the glow plug 32, and the fuel injection timing is controlled to the delay side by 1 CA [deg]. As a result, there can be attained a remarkable effect of decreasing torque variation (FIG. 5), combustion noise (FIG. 6), the amount of generated NOx (FIG. 7), the amount of generated CO (FIG. 8), the amount of generated THC (FIG. 9), etc., as compared with the case where the glow plug 32 is not energized, while securing a necessary engine torque.

### C. Modifications:

### C-1) First modification:

In the above-described embodiment, a ceramic-type glow plug is used as the glow plug 32, and the temperature of the glow plug 32 is increased to 1300°C. However, as shown in the drawings, the heating temperature of the glow plug is at least 900°C, and more preferably 1100°C or higher. Even a metal-type glow plug can achieve the heating when the heating temperature is about 900°C.

### C-2) Second modification:

In the above-described embodiment, the glow plug is energized and the fuel injection timing is delayed. However, the above-described embodiment may be modified in such a manner that the fuel injection timing is not delayed and a large torque is taken out from the engine 10. Alternatively, the above-described embodiment may be modified to decrease the fuel injection amount accordingly, while maintaining the torque taken out from the engine 10 at the same level.

### C-3) Third modification:

In the above-described embodiment, the determination as to whether or not to enter the premixed combustion region is made on the basis of the vehicle speed V and the accelerator depression amount α, and the glow plug 32 is energized. Subsequently, after elapse of a wait time (e.g., 3 seconds) required for temperature increase, the operation of the engine is switched to the operation in the premixed combustion mode. However, the wait time may be shorten to a time shorter than 3 seconds, for example, about 0.1 to 2.5 seconds. In particularly, in the case where a glow plug which has high performance and reaches a high temperature within a short period of time is employed, the wait time can be shortened accordingly. Also, the above-described embodiment may be modified to perform pre-heating by supplying to the glow plug an electrical power smaller than that at the time of heating, to thereby increase the temperature of the glow plug to a predetermined temperature within a short period of time.

### C-4) Fourth modification:

In the above-described embodiment, the energization of the glow plug is performed after the engine has entered the premixed combustion region (FIG. 3(A)). However, the embodiment may be modified to perform the energization of the glow plug before the engine enters the premixed combustion region by predicting a change in the required load of the engine. In the example shown in FIG. 3(A), when the vehicle speed V and the accelerator depression amount α change from the point A1 to the point A2, then to the point A3, and then the point A4, it can be predicted that the engine will soon enter the premixed combustion region. When the energization of the glow plug is performed upon performance such prediction, the operation of the engine can be quickly switched to the operation in the premixed combustion mode, whereby fuel cost can be reduced. Also, in the above-described embodiment, as indicated by a solid line GA in FIG. 3(B), when the transition period ends, the energization of the glow plug 32 is stopped. However, it is not necessarily required to stop the energization of the glow plug at the end of the transition period. The energization of the glow plug may be continued during a period during which the engine is operated in the premixed combustion mode. Alternatively, as indicated by a broken line GB in FIG. 3(B), the energization of the glow plug 32 may be continued in a state in which the electrical power supplied to the glow plug has been decreased to decrease the elevated temperature to a temperature equal to or lower than 1300°C; for example, to about 900°C. In the case where the engine and the catalyst have not yet been warmed up sufficiently (e.g., at the time of warming up operation), the THC generation amount can be decreased by continuing the energization of the glow plug 32. Alternatively, the supply of electric power to the glow plug 32 may be controlled as indicated by an alternate long and short dash line GC in FIG. 3(B). Specifically, the supply of electric power to the glow plug 32 is stopped temporarily, and electric power is supplied to the glow plug 32 when necessary to thereby heat the glow plug 32 to a predetermined temperature. For example, in the case where the catalyst is judged not to exhibit a sufficient degree of activity on the basis of a signal from a sensor provided in the exhaust passage, the supply of electric power to the glow plug 32 may be resumed.

### C-5) Fifth modification:

In the above-described embodiment, the fuel injection timing in the premixed combustion mode is determined in advance. However, it may be determined by feedback control using various parameters. Although the torque, the torque variation, the NOx generation amount, etc. can be used as parameters for such feedback control, it is also desired to compute a pressure increase rate maximum value dPmax through use of a signal from a cylinder pressure sensor provided in the glow plug 32 and perform the feedback control such that the value falls within a predetermined range. This is because the pressure increase rate maximum value dPmax is excellent as an index for controlling the fuel injection timing at the time of premixed combustion. The pressure increase rate maximum value dPmax has a strong correlation with the fuel injection timing with the EGR ratio serving as a parameter. Accordingly, when the fuel injection timing is feedback-controlled such that the pressure increase rate maximum value dPmax becomes equal to a target dPmax, combustion noise, the amount of generated NOx, the amount of generated CO, the amount of generated soot (opacity), etc. can be suppressed.

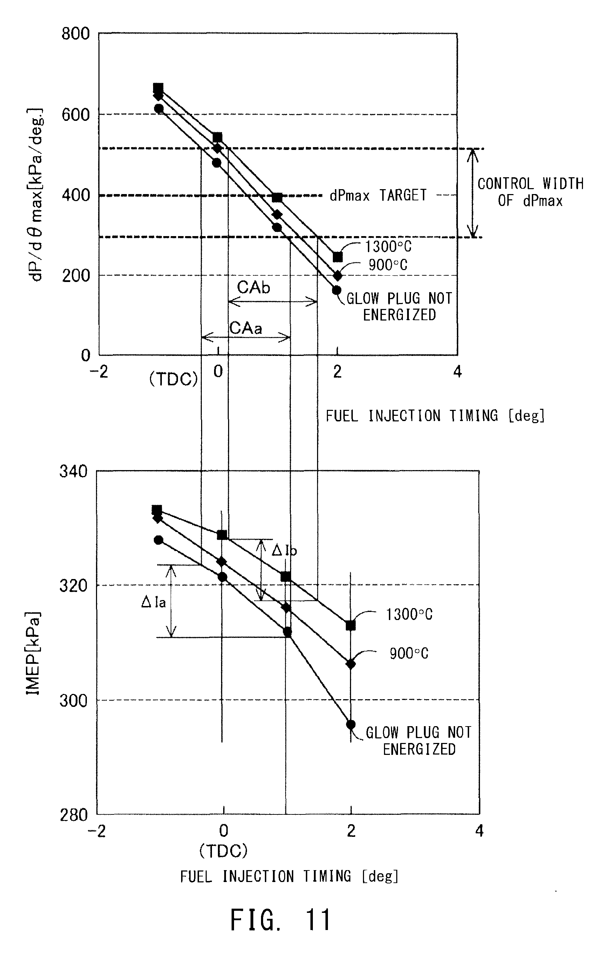

In addition, it has been found that it is more preferred to perform the feedback control of fuel injection timing based on the pressure increase rate maximum value dPmax in a state in which the glow plug 32 is heated to a high temperature. FIG. 11 includes a graph (in an upper section of FIG. 11) which shows the relation between fuel injection timing and the pressure increase rate maximum value dPmax and in which the elevated temperature of the glow plug 32 is used as a parameter, and a graph (in a lower section of FIG. 11) which shows the relation between fuel injection timing and torque (indicated means effective pressure (IMEP)) and in which the elevated temperature of the glow plug 32 is used as a parameter. Notably, in this example, the EGR ratio was 30%.

As can be understood from FIG. 11, when the elevated temperature of the glow plug 32 changes, the relation between the fuel injection timing and the pressure increase rate maximum value dPmax changes. However, the control range CAa, CAb of the fuel injection timing for controlling the pressure increase rate maximum value dPmax to the target range is substantially the same irrespective of the elevated temperature of the glow plug 32. However, the higher the elevated temperature of the glow plug 32, the smaller the variation ΔIa, ΔIb of the indicated means effective pressure (IMEP) in the control range CAa, CAb of the fuel injection timing (ΔIb < ΔIa) as shown in the lower section of FIG. 11. Accordingly, when the engine 10 is controlled in the premixed combustion mode, the engine 10 can be operated properly by feedback-controlling the fuel injection timing through use of the pressure increase rate maximum value dPmax. Further, by performing the energization of the glow plug 32, it is possible to reduce combustion noise, and to further reduce the amount of generated NOx, the amount of generated CO, the amount of generated soot (opacity), torque variation, etc.

In place of or in addition to the above-described pressure increase rate maximum value dPmax, a heat release rate maximum value dQmax may be used. Also, when control is performed through use of these parameters, the correlation among the EGR ratio, the pressure increase rate maximum value dPmax (or the heat release rate maximum value dQmax) and the fuel injection timing may be obtained in advance so as to prepare a map, based on which feedback control is performed. However, simple control may be used as follows. In this case, a target value of the pressure increase rate maximum value dPmax is first determined, and a pressure increase rate maximum value dPmax obtained by processing the signal from the cylinder pressure sensor is compared with the target value. When the pressure increase rate maximum value dPmax is greater the target value, the fuel injection timing in the premixed combustion mode is controlled to the delay side by a predetermined CA angle, and when the pressure increase rate maximum value dPmax is less the target value, the fuel injection timing in the premixed combustion mode is controlled to the advance side by a predetermined CA angle. By such simple control, proper fuel injection timing can be realized.

### C-6) Sixth modification:

In the above-described embodiment, the energization of the glow plug is performed at the time of transition to the premixed combustion mode. However, the energization of the glow plug may be performed when the EGR ratio becomes equal to or greater than a predetermine ratio; for example, becomes 60% or greater. The EGR ratio can be obtained on the basis of the signal from the oxygen concentration sensor 53. Alternatively, the EGR ratio may be predicted from the openings of the first and second EGR valves 37 and 22. Also, the EGR ratio for the energization of the glow plug may be smaller or larger than 60%, and may be determined in accordance with the characteristics of the diesel engine.

### D. Second embodiment:

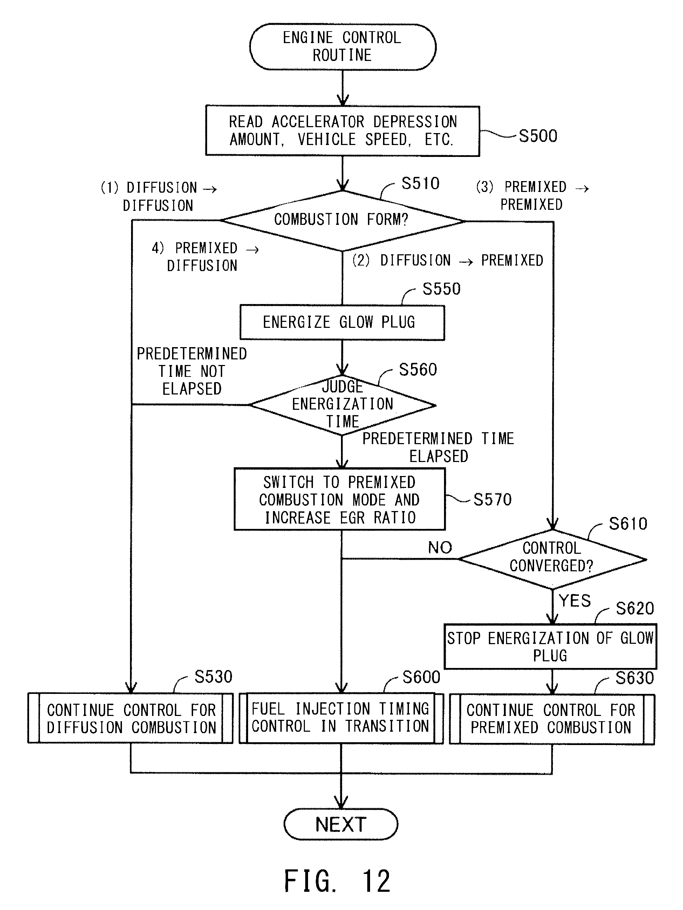

Next, a second embodiment of the present invention will be described. An engine control apparatus 100 of the second embodiment has the same configuration as the control apparatus of the first embodiment, and differs from the control apparatus of the first embodiment in the engine control routine only. FIG. 12 shows the engine control routine in the second embodiment.

The ECU 70, which constitutes the engine control apparatus 100 of the second embodiment, repeatedly executes the control routine shown in FIG. 12 when the engine 10 is started. When this routine is started, as in the case of the first embodiment, the ECU 70 first receives the signals from the various sensors of the vehicle, such as the accelerator sensor 61 and the vehicle speed sensor 64, and reads the accelerator depression amount α, the vehicle speed V, etc. (step S500). Subsequently, the ECU 70 determines the combustion form from the accelerator depression amount α, the vehicle speed V, etc. (step S510).

The determination of the combustion form performed here contains determination of the current combustion form and determination of a combustion form to be realized next (target combustion form). As shown in FIG. 3(A), in general, the premixed combustion mode is employed in a low-speed/low-load region, and the diffusion combustion mode is selected in a region in which the load of the engine is high. Operation regions in which the engine operates in the premixed combustion mode is determined in advance, and stored in the ROM 72 or the like in the form of a map. FIGS. 3(A) and 3(B) show an example of the behavior of the engine 10. In this example, the determination of the combustion form is performed as follows.
(1) For example, when the load does not change from the state indicated by A3 in FIG. 3(A) or moves to the state indicated by A4 as a result of changing, the current combustion form is diffusion combustion, and the target combustion form is also diffusion combustion.
(2) For example, when the load changes from the state indicated by A4 to the state indicated by A5, the current combustion form is diffusion combustion, and the target combustion form is premixed combustion.
(3) For example, when the load does not change from the state indicated by A5 in FIG. 3(A) or moves to a state in which the load is smaller than that in the state indicted by A5 as a result of changing, the current combustion form is premixed combustion, and the target combustion form is also premixed combustion.
(4) For example, when the load moves from the state indicated by A5 in FIG. 3(A) to the state indicted by A4, the current combustion form is premixed combustion, and the target combustion form is diffusion combustion. However, in the present embodiment, in the case (4), control for diffusion combustion is performed, and the combustion is controlled in the same manner as in the case (1).

In the cases (1) and (4), control for diffusion combustion is continued (step S530). In the case of diffusion combustion, fuel is injected into each cylinder near the top dead center (TDC). The fuel injection amount and the fuel injection timing may be previously determined in accordance with the required load (the vehicle speed and the accelerator depression amount, etc.). Notably, in the case of diffusion combustion, the EGR ratio is set to a small value.

In the case (2); namely, in the case where the current combustion form is diffusion combustion and the target combustion form is premixed combustion, as in the first embodiment, the ECU 70 starts the energization of the glow plug 32 (step S550). When the energization is started, the temperature of the glow plug 32, which is employed in the present embodiment and includes a ceramic heater, increases rapidly. An example of such a glow plug 32 including a ceramic heater and a pressure sensor is shown in, for example, Japanese Patent Application Laid-Open (*kokai*) No. 2013-257133, etc. Such a glow plug 32 requires only several seconds to reach a predetermined temperature (e.g., 1000°C). In view of this, the ECU 70 then performs a judgment on the energization time of the glow plug 32 (step S560). When the energization time of the glow plug 32 is shorter than a predetermined time, the ECU 70 proceeds to the control for diffusion combustion having already been described (step S530) so as to continue the control for diffusion combustion. The ECU 70 goes to a next process "NEXT" to thereby temporarily end the present control routine.

When the control routine shown in FIG. 12 is repeatedly executed, the energization time of the glow plug 32 finally reaches the predetermined time. The predetermined time is set to, for example, about 3 seconds in consideration of the time required for the glow plug 32 to reach 1000°C from the start of the energization. When the predetermined time has elapsed from the start of the energization of the glow plug 32, the ECU 70 determines in step S560 that "predetermined time has elapsed," and performs processing for switching to the premixed combustion mode and increasing the EGR ratio (step S570). This processing is the basically the same as the processing shown in the first embodiment (FIG. 2, step S300). After that, the ECU 70 proceeds to step S600, and performs transition-time fuel injection timing control. The transition-time fuel injection timing control of step S600 is realized by the processing which has been described as the fifth modification of the first embodiment (section C-5). Namely, the fuel injection timing is feedback-controlled through use of the pressure increase rate maximum value or the heat release rate maximum value. The control basically corresponds to that of the first embodiment (FIG. 2, step S400). After performing the transition-time fuel injection timing control, the ECU 70 goes to a next process "NEXT" to thereby temporarily end the present control routine.

When the present control routine is started again, since the combustion mode has been switched to the premixed combustion mode (step S570), the ECU 70 determines in step S510 that the current combustion state is premixed combustion and the target combustion state is also premixed combustion (the case (3)). In this case, the ECU 70 first determines whether or not the control has converged (step S610). When the combustion form is switched to premixed combustion, the EGR ratio increases gradually, the control based on the pressure increase rate maximum value or the heat release rate maximum value converges. However, the control requires a predetermined time to converge. Before the control converges, the ECU 70 continues the transition-time fuel injection timing control (step S600). In the present embodiment, the phrase "the control has converged" means that the pressure increase rate maximum value or the heat release rate maximum value has fallen within a target range or that the sensitivity of the pressure increase rate maximum value or the like to a change in the fuel injection timing has become zero.

Meanwhile, in the case where the ECU 70 determines that the control has converged (step S610: "YES"), the ECU 70 stops the energization of the glow plug 32 having been continued (step S620). After that, since the control at the time of transition ends, the ECU 70 starts and continues the control for premixed combustion (step S630). In the case of premixed combustion, the ECU 70 obtains the fuel injection amount at the time of low load, divides it into those for the pilot injection and the main injection, and injects fuel at predetermined injection timings. After that, the ECU 70 goes to a next process "NEXT" to thereby temporarily end the present control routine. Even after this, as long as the diesel engine 10 is operated, the ECU 70 repeatedly executes the present control routine to thereby perform, on the basis of the combustion state and its transition, the energization of the glow plug 32, the control of the EGR ratio, and one of the control for diffusion combustion, the control for premixed combustion, and the control at the time of transition.

The above-described engine control apparatus 100 of the second embodiment can properly perform the control in the diffusion combustion mode, the control in the premixed combustion mode, the combustion control at the time of transition on the basis of the operation state of the diesel engine 10, and can accurately control the energization of the glow plug 32, while repeatedly executing the control routine shown in FIG. 12. As a result, the engine control apparatus 100 of the second embodiment yields the same effects as those of the first embodiment, and can perform the control more accurately.

### E. Design of fuel injection timing:

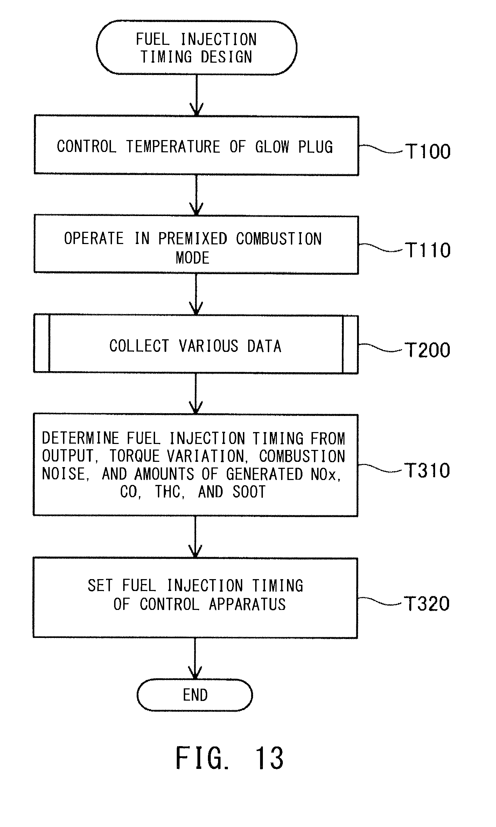

Next, a method for designing fuel injection timing will be described as a third embodiment of the present invention. FIG. 13 is a flowchart showing a process of designing fuel injection timing. In the case where the fuel injection timing in a predetermined engine is designed, as shown in FIG. 1, the engine 10 is first incorporated into the intake-exhaust system 20 in which the engine 10 is actually operated, and the temperature of the glow plug is controlled (step T100). It is desirable that temperature detection means, such as thermocouple, be incorporated into the engine so as to detect the actual temperature of the glow plug.

Next, the engine is operated in the premixed combustion mode (step T110). When the engine is operated, the EGR ratio is increased gradually as in the actual case. Data from the various sensors provided on the engine 10 are collected (step T200). The various type of data may include not only data from the sensors shown in FIG. 1 but also data from sensors provided for measurement. An example of the sensors for measurement is a sensor for detecting the cetane value of fuel.

Next, the output of the engine, torque variation, combustion noise, and the amounts of generated NOx, CO, THC, and soot are comprehensively determined from the obtained data, and the fuel injection timing at each EGR ratio is determined (step T310). Such processing is repeated, the repetition of the processing is performed while the temperature of the glow plug is changed, and the fuel injection timing in the transition state when the combustion mode is switched to the premixed combustion mode is set in the form of a map (step T320). The map obtained in this manner is provided by being written into the ROM 72 of the ECU 70, which is a control apparatus for actually controlling the engine 10. When the combustion mode is switched to the premixed combustion mode, the ECU 70 controls the fuel injection timing with reference to the map written into the ROM 72.

The above-described fuel injection timing designing method can determine the fuel injection timing at the time of transition to the premixed combustion mode in accordance with the heating temperature of the glow plug such that proper characteristics can be obtained. As a result, as described in the first embodiment, it becomes possible to operate the engine in the premixed combustion mode which reduces torque variation, combustion noise, etc., while securing the required torque.

### F. Modification:

In the above-described fuel injection timing designing method, the output of the engine, torque variation, combustion noise, and the amounts of generated NOx, CO, THC, and soot are comprehensively considered for determination of the fuel injection timing. However, it is sufficient that the fuel injection timing is determined in consideration of at least one of these parameters. Alternatively, the fuel injection timing may be determined in consideration of a larger number of parameters. For example, mass fraction burned (MFB), heat release rate, etc. may be taken into consideration.

The present invention is not limited to the above-described embodiments, examples, and modifications, but may be embodied in various other forms without departing from the spirit of the invention. For example, in order to solve, partially or entirely, the above-mentioned problem or yield, partially or entirely, the above-mentioned effects, technical features of the embodiments, examples, and modifications corresponding to technical features of the modes described in the section "Summary of the Invention" can be replaced or combined as appropriate. Also, the technical feature(s) may be eliminated as appropriate unless the present specification mentions that the technical feature(s) is mandatory.

### [Description of Reference Numerals]

- 10:: diesel engine
- 11:: gear wheel
- 12:: intake pipe
- 14:: intake valve
- 15:: turbocharger
- 17:: inter cooler
- 18:: inter cooler passage throttle valve
- 20:: intake-exhaust system
- 21:: manifold
- 22:: second EGR valve
- 24:: fuel supply pump
- 26:: common rail
- 30:: fuel injection valve
- 32:: glow plug
- 33:: branch pipe
- 34:: oxidation catalyst
- 36:: DPF
- 37:: first EGR valve
- 38:: exhaust shutter
- 51:: intake gas temperature sensor
- 52:: intake pressure sensor
- 53:: oxygen concentration sensor
- 55:: exhaust gas temperature sensor
- 57:: opacity sensor
- 59:: NOx sensor
- 61:: accelerator sensor
- 62:: accelerator
- 64:: vehicle speed sensor
- 70:: ECU
- 71:: CPU
- 72:: ROM
- 73:: RAM
- 74:: CAN
- 75:: input port
- 76:: output port
- 80:: in-vehicle LAN
- 100:: diesel engine control apparatus

## Claims

1. A diesel engine control apparatus (FIG. 1, 100) for controlling combustion in a diesel engine, comprising:
a cylinder heater (FIG. 1, glow plug 32) for heating the interior of a cylinder of the diesel engine (FIG. 1, 10); and
a control unit (FIG. 1, ECU 70) which performs the heating of the interior of the cylinder by the cylinder heater (FIG. 1, glow plug 32) when the diesel engine is switched to premixed combustion in a state in which EGR is being performed (FIG. 2, step S120), and performs at least fuel injection timing control for the diesel engine (FIG. 1, 10) (FIG. 2, step S400).

2. A diesel engine control apparatus according to claim 1, wherein the control unit (FIG. 1, ECU 70) controls the EGR when the diesel engine is switched to the premixed combustion such that the EGR ratio becomes equal to or greater than a predetermined EGR ratio (FIG. 2, step S300).

3. A diesel engine control apparatus according to claim 2, wherein the control unit (FIG. 1, ECU 70) performs control of the fuel injection timing to a delay side while controlling the EGR such that the EGR ratio becomes equal to or greater than the predetermined EGR ratio (FIG. 2, step S300).

4. A diesel engine control apparatus according to any one of claims 1 to 3, wherein the heating by the cylinder heater (FIG. 1, glow plug 32) is performed immediately before the diesel engine is switched to the premixed combustion.

5. A diesel engine control apparatus according to any one of claims 1 to 4, wherein the cylinder heater (FIG. 1, glow plug 32) is a glow plug which can increase its temperature to 900°C or higher.

6. A diesel engine control apparatus according to claim 5, wherein the glow plug has a temperature increase speed such that the glow plug reaches 1200°C within a period of 0.5 sec to 3 sec (FIG. 1, glow plug 32).

7. A method for controlling combustion in a diesel engine, comprising:
heating the interior of a cylinder of the diesel engine (FIG. 1, 10) by a cylinder heater (FIG. 1, glow plug 32) when the diesel engine is switched to premixed combustion in a state in which EGR is being performed (FIG. 2, step S120); and
performing at least fuel injection timing control for the diesel engine (FIG. 1, 10) (FIG. 2, step S400).

8. A method for designing a control apparatus for controlling combustion in a diesel engine, comprising:
measuring a delay angle limit of fuel injection timing control at the time when the diesel engine is switched to premixed combustion, while using, as parameters, a heating temperature of a cylinder heater (FIG. 1, glow plug 32) which heats the interior of a cylinder of the diesel engine (FIG. 1, 10) and an EGR ratio of the diesel engine (FIG. 13, steps T100 to T200);
determining, on the basis of results of the measurement, an advancing amount of the fuel injection timing control of the diesel engine at the time when the diesel engine is switched to premixed combustion, the advancing amount being determined for each value of the EGR ratio in the case where the interior of the cylinder is heated to a predetermined temperature by the cylinder heater (FIG. 13, steps T310); and
designing the control unit to control the fuel injection timing of the diesel engine on the basis of the determined advancing amount when the diesel engine is switched to the premixed combustion (FIG. 13, steps T320).

9. A method for designing a diesel engine control apparatus according to claim 8, wherein the control of the fuel injection timing performed by the control unit is controlling the fuel injection timing to the determined advancing amount, for each value of the EGR ratio, under the premise that the heating temperature of the cylinder heater is the predetermined temperature, when the diesel engine is switched to the premixed combustion (FIG. 13, steps T310).

10. A method for designing a diesel engine control apparatus according to claim 8 or 9, wherein the advance amount by which the fuel injection timing is advanced by the control unit is determined such that combustion noise of the diesel engine or at least one of NOx, CO, THC, and soot in exhaust gas is suppressed.
